# EUROPEAN PATENT APPLICATION

(11) **EP 4 760 397 A2**
(43) Date of publication of application: **17.06.2026**
(21) Application number: 26173367.9
(22) Date of filing: 22.11.2022
(51) Int. Cl.: G03F 7/20

(54) **UVC LED LIGHT FINISHER FOR DETACKING FLEXOGRAPHIC PRINTING PLATES**

(30) Priority: 22.11.2021 US 202163281904 P
(62) Divisional of application: 22840296.2
(71) Applicant: Esko-Graphics Imaging GmbH, 25524 Itzehoe (DE)
(72) Inventor: KLEIN, Thomas, 38302 Wolfenbuettel (DE); THOMAS, Pascal, 22337 Hamburg (DE); SIEVERS, Wolfgang, 25569 Kremperheide (DE); BRUCE, Robert, West Hallam, DE7 6LX (GB)
(74) Representative: Müller-Boré & Partner Patentanwälte PartG mbB

(57) **Abstract**

A processing system (1) for processing a printing plate (P) comprising an imager (10) for imaging a printing plate (P), an exposure unit (11) for exposing a printing plate (P) imaged by the imager (10), a developer (12) for developing a printing plate (P) exposed by the exposure unit (11), and a control device (17) for controlling plate making processes performed by the imager (10), the exposure unit (11) and the developer (12).

## Description

### CROSS REFERENCE TO RELATED APPLICATIONS

This application claims priority from U.S. Provisional Application Ser. No. 63/281,904, titled "UVC LED LIGHT FINISHER FOR DETACKING FLEXOGRAPHIC PRINTING PLATES," filed November 22, 2021, incorporated herein by reference in its entirety for all purposes.

### BACKGROUND OF THE INVENTION

This disclosure relates to systems and methods for improving surface properties of photo-curable printing plates. Exemplary photo-curable printing plates known in the art include photopolymer flexographic printing plates, letterpress plates and other polymer (or monomer) printing plates, as well as polymer (or monomer) sleeves and polymer (or monomer) coated printing cylinders, and serigraph (screen) printing plates using photo-curable emulsions. Photo-curable, as used herein, refers to a polymer or monomer that is curable by actinic radiation. To the extent the term "photopolymer" is used herein, it should be understood to refer to any compound with photo-curable properties, whether technically a polymer or a monomer. "Actinic radiation" is typically light in the ultraviolet (UV) range, but is not limited to any particular wavelength or range of wavelengths. As is known in the art, the UV region of the spectrum covers the wavelength range 100-400 nm and is divided into three bands: UVA (315-400 nm), UVB (280-315 nm), and UVC (100-280 nm).

Photopolymer plates have found a broad range of applications. A variety of different methods can be applied for transferring an image for printing, e.g., in the form of imaging data, to a polymer plate. Exemplary methods and systems include an image mask that regulates passage of radiation through the mask and is placed on top of a polymer sheet, which mask may be, for example and without limitation, in the form of a film having an imageable layer that is thermally sensitive or photosensitive applied to the surface of the plate, or a layer disposed on top of the polymer surface that is laser ablated.

For example, in digital flexography, a photopolymer plate is exposed to imaging data through a mask disposed on the photopolymer plate. In embodiments, the mask is formed using laser ablation in an imaging device. A typical digital flexographic printing plate is produced from the photopolymer plate in an (e.g. organic) solvent development process by the following process steps:
1. Applying UVA back exposure to the photopolymer plate to form a base for printing structures.
2. Imaging a mask into a Laser Ablated Mask (LAMs) layer on top of the photopolymer plate.
3. Applying UVA front exposure through the imaged LAMs layer to form the printing structures.
4. Washing to remove non-cured portions of the photopolymer plate.
5. Drying in an oven to remove solvent from the washing process.
6. Applying UVA post exposure for complete curing of all non-cured portions of the photopolymer plate.
7. UVC light finishing for detacking (removing stickiness from) the photopolymer plate.

Aqueous development processes (in which the solvent is water-based) may not require a separate drying step. Thermal development processes (for plates made with polymer or monomer that is removed by heating and blotting) use the thermal process to remove the non-cured portions instead of steps 4 and 5 above.

As used herein, the term "photopolymer plate" or "photopolymer precursor" may be used to refer to a plate prior to or during processing, and "printing plate" may be used to refer to a fully-processed plate that is ready to receive ink for printing when needing to differentiate between the precursor and the completed plate. The terms may also be used interchangeably with one another to refer to either state of the plate, when such differentiation is not required.

Historically, in some process workflows, some, but not all, of the above described steps have been combined in the same apparatus. For example, the main exposure (including front and back exposure) steps are typically executed in the same apparatus. Also, the processes of drying, the post exposure and detacking are sometimes combined in one unit (apparatus), although the drying and UV exposure functions may be executed in different drawers of the same apparatus.

The processes of producing flexographic printing plates have evolved from individual systems for the various process steps towards automation and integration of all the various process steps into one centrally controlled system. Thus, the processes of the UV post exposure and the UV light finishing (detacking) are also physically integrated into the process chain with respect to such a centrally controlled system. For example, these two processes are combined with the drying process step in units such as the Vianord EVO 4 DFL unit, the DuPont^{®} ECDFL 2000 unit, and the like.

However, in these conventional drying oven systems, the UV generation is realized by means of low pressure mercury plasma tubes, also typically referred to as fluorescent tubes or a fluorescent lamp having fluorescent tubes. These tubes are inexpensive but have only a limited lifetime (between 1000 and 2000 hours) and need to be replaced on a regular base. Furthermore, they contain mercury, which is environmentally problematic.

When the UV generation is implemented into a greater surrounding system, access to these tubes is more restricted. Therefore, it will be advantageous to replace these tubes by LEDs that have significantly longer lifetime, which allows longer periods of maintenance free operation.

Since the first "Inline UV" LED curing system for photopolymer printing plates was introduced by ESKO in 2007 (US8389203B2), LEDs have become a standard in the flexography for the UVA main exposure. However, the UVA post exposure and the UVC light finishing have been still applied by means of fluorescent tubes. This is mainly because of lower quality requirements for the UV post exposure and the UV light finishing in comparison to the UVA main exposure, technical simplicity of the fluorescent tubes, and the low costs for the fluorescent tubes.

Recently, UVA LEDs and UVC LEDs have made remarkable progress, in which both output power and lifetime of UVA LEDs and UVC LEDs have been increased and prices thereof have been decreased to an extent that allows broad use in various industrial applications. For example, UVC LEDs are now used in various irradiating systems that have close to 100 mW light power output and emit in the UVC range of 273-280 nm.

Thus, exploring the use of LEDs beyond use in the main exposure steps of a printing plate manufacturing workflow is of interest.

### SUMMARY OF THE INVENTION

One aspect of the invention comprises an apparatus for exposing a partially processed photopolymer printing plate to post-exposure radiation and finishing radiation, the printing plate defining a whole area having a first full lateral dimension and a second full lateral dimension perpendicular to the first lateral dimension. The apparatus comprises a plurality of light-emitting diodes (LEDs) arranged in one or more arrays, the plurality of LEDs including at least a first set of LEDs configured to emit the post exposure radiation in a UVA spectral range and a second set of LEDs configured to emit the finishing radiation in a UVC spectral range; a surface for receiving the printing plate in a location disposed to receive the post exposure radiation and the finishing radiation; one of more controllers connected to the one or more arrays and configured to activate the one or more arrays to cause the plurality of sets of LEDs to emit radiation toward the printing plate.

In some embodiments, the first set of LEDs is arranged in a first lamp and the second set of LEDs is arranged in a second lamp. In some embodiments, the first set of LEDs and the second set of LEDs are arranged in a single lamp. In some embodiments, the one or more arrays are configured to expose the whole area of the printing plate.

In some embodiments, the one or more arrays are configured to expose the full first lateral dimension of the printing plate over less than the full second lateral dimension of the printing plate. The apparatus may comprise means for causing relative motion between the printing plate and the one or more arrays. The one or more arrays are configured to be stationary and the means is configured to move the plate. The means for causing relative motion includes a drum that defines the surface for receiving the printing plate and that is configured to rotate relative to the one or more arrays.

In some embodiments, the surface for receiving the printing plate is configured to hold the printing plate in a stationary configuration, wherein the means for causing relative motion includes a carriage configured to move the one or more arrays in a first lateral direction relative to substrate.

In some embodiments, the one or more arrays are configured to expose less than the full first lateral dimension of the printing plate over less than the full second lateral dimension of the printing plate. The apparatus may comprise means for causing relative motion includes a drum that defines the surface for receiving the printing plate and that is configured to rotate relative to the one or more arrays, and means for moving the one or more arrays axially relative to the drum.

In some embodiments, the surface for receiving the printing plate is configured to hold the printing plate in a stationary configuration. The means for causing relative motion includes a gantry configured to move the one or more arrays in a first lateral direction relative to substrate, and a carriage configured to move the one or more arrays relative to the gantry in a second lateral direction perpendicular to the first lateral direction.

In some embodiments, the one or more controllers includes a first controller configured to independently control power to the first set of LEDs and a second controller configured to independently control power to the second sets of LEDs, wherein the first controller and the second controller are configured to cause the first set of LEDs to emit a different intensity than the second set of LEDs.

In some embodiments, the one or more controllers are configured to cause at least the first set of LEDs to have a different exposure time than at least the second set of LEDs. In some embodiments, the first set of UV LEDs is also configured to emit front side main exposure radiation toward the front side of the printing plate disposed on the surface.

The apparatus may further comprise at least one third set of UV LEDs configured to emit a back side main exposure radiation toward the back side of the printing plate disposed on the surface. The one or more controllers is configured to cause the at least one third set of LEDs to emit radiation toward the printing plate.

In some embodiments, the printing plate further comprises a laser ablated masking (LAMS) layer, and the apparatus further comprises an imager configured to laser ablate the LAMS layer in accordance with imaging information. The apparatus may comprise a plate dryer. The apparatus may comprise a thermal plate processor.

Another aspect of the invention comprises a method for exposing a partially processed photopolymer printing plate to post-exposure radiation and finishing radiation, the method comprises (a) providing the apparatus as described above, (b) disposing a printing plate on the surface, (c) irradiating the printing plate with post-exposure radiation from the first set of LEDs, and (d) irradiating the printing plate with the finishing radiation from the second set of LEDs.

Still another aspect of the invention comprises a method for exposing a partially processed photopolymer printing plate to post-exposure radiation and finishing radiation, the printing plate defining a whole area having a first full lateral dimension and a second full lateral dimension perpendicular to the first lateral dimension. The method comprises (a) partially processing the photopolymer printing plate by performing at least a main UV exposure step; (b) removing non-cured polymer portions of the photopolymer printing plate by at least one of a thermal plate processor, a solvent-based plate processor, or a water-based plate processor; (c) providing a plurality of light-emitting diodes (LEDs) arranged in one or more arrays, the plurality of LEDs including at least a first set of LEDs configured to emit the post exposure radiation in a UVA spectral range and a second set of LEDs configured to emit the finishing radiation in a UVC spectral range; (d) irradiating the partially processed photopolymer printing plate with the post exposure radiation from the first set of LEDs for a first exposure time; and (e) irradiating the partially processed photopolymer printing plate with the finishing radiation from the second set of LEDs for a second exposure time. Each execution of step (d) and step (e) comprises an exposure cycle, and each exposure cycle defines an energy contribution.

The method may comprises executing two or more consecutive exposure cycles. The method may comprise executing step (d) and step (e) simultaneously, or executing step (d) and step (e) in alternation.

In some embodiments, the energy contribution per exposure cycle is constant; the energy contribution per exposure cycle increases over time; the energy contribution per exposure cycle decreases over time; or the energy contribution per exposure cycle increases over time for one of the first set of LEDs or the second set of LEDs and decreases over time for the other of first set of LEDs or the second set of LEDs.

In some embodiments, the printing plate defines a whole area having a full first lateral dimension and full second lateral dimension perpendicular to the first lateral dimension, and each of step (c) and step (d) comprises irradiating the whole area of the plate without movement of the plate, the first set of LEDs, or the second set of LEDs.

In some embodiments, the printing plate defines a whole area having a full first lateral dimension and full second lateral dimension perpendicular to the first lateral dimension, and the one or more arrays are configured to expose the less than one or both of the full first lateral dimension or the second lateral dimension, the method further comprising causing relative movement between the printing plate and the one or more arrays.

The method may comprise independently controlling each of the first set of LEDs and the second sets of LEDs to control one or more of intensity, exposure time, and wavelength composition; controlling the one or more of intensity, exposure time, and wavelength composition of the first set of LEDs and the second set of LEDs to optimize ink transfer properties of the printing plate.

In some embodiments, partially processing the photopolymer flexographic printing plate includes removing uncured polymer after performing the main UV exposure step, the method comprising independently controlling each of the first set of LEDs and the second sets of LEDs to control one or more of intensity, exposure time, and wavelength composition in one or more exposure cycles to optimize durability of the photopolymer flexographic printing plate. In particular, the durability optimization may be important for plates that use a solvent-containing printing ink.

Still another aspect of the invention includes a method of processing a photosensitive flexographic printing plate, including the steps of erforming a main exposure step, including (a) a back exposure substep and a front exposure substep, resulting in cured polymer in the printing plate corresponding to areas of the plate exposed during the main exposure step and uncured polymer corresponding to areas of the plate not exposed during the main exposure step, (b) removing the non-cured polymer from the printing plate; (c) optionally, drying the printing plate; (d) irradiating the printing plate with a set of UVA LEDs for a first exposure time; and (e) irradiating the printing plate a set of UVC LEDs for a second exposure time.

In embodiments, the method further comprises the step of forming a mask over a photosensitive layer of the printing plate.

In embodiments, steps (c), (d), and (e); steps (b), (d), and (e); or steps (a), (d), and (e) may be performed by a same piece of process equipment. Step (e) may be performed after step (a) but before step (b), and in some instances, may include performing step (e) again after performance of steps (b) and (c). In embodiments, steps (d) and (e) are performed using stationary UVA LEDs and stationary UVC LEDs on a moving plate after performance of the drying step (c) downstream of a washing step in step (b).

In embodiments, the step of forming the mask and steps (a), (d), and (e); the step of forming the mask and steps (a), (c), (d), and (e); or the step of forming the mask and steps (a), (b), (d), (e), and optionally (c), are all performed by a same piece of process equipment.

Still another aspect of the invention comprises a method of processing a photosensitive flexographic printing plate, the printing plate comprising a Laser Ablated Masking (LAMs) layer disposed over a photosensitive layer. The method comprises the steps of (a) laser ablating the LAMs layer with an imager in accordance with imaging information to form a mask; (b) performing a main exposure step, including a back exposure sub-step and a front exposure sub-step, resulting in cured polymer in the printing plate corresponding to areas of the plate exposed during the main exposure step and uncured polymer corresponding to areas of the plate not exposed during the main exposure step; (c) removing the non-cured polymer from the printing plate; (d) optionally, drying the printing plate; and (e) irradiating the printing plate with a set of UVA LEDs for a first exposure time; and (f) irradiating the printing plate a set of UVC LEDs for a second exposure time.

In some embodiments, steps (d), (e), and (f) are performed by a same piece of process equipment. In some embodiment, steps (c), (e), and (f) are performed by a same piece of process equipment. In some embodiments, steps (b), (e), and (f) are performed by a same piece of process equipment. In some embodiments, step (f) is performed after step (b) but before step (c), and in some of those embodiments, step (f) is performed again after performing steps (c) and (d). In some embodiment, steps (a), (b), (e), and (f) are performed by a same piece of process equipment.

In some embodiment, steps (a), (b), (d), (e), and (f) are performed by a same piece of process equipment. In some embodiment, steps (a), (b), (c), (d), (e), and (f) are all performed by a same piece of process equipment. In some embodiment, steps (e) and (f) are performed using stationary UVA LEDs and stationary UVC LEDs on a moving plate after performance of the drying step (d) downstream of a washing step in step (c).

### BRIEF DESCRIPTION OF THE DRAWINGS

FIG. 1A schematically illustrates a workflow of creating a printing plate from a photopolymer precursor using a plurality of process machines including a finishing apparatus according to one exemplary embodiment.
FIG. 1B schematically illustrates an exemplary processing system installation, showing schematic process steps operating on plates as they move through an exposure process according to one exemplary embodiment.
FIGS. 2A and 2B schematically illustrate exemplary post exposure and finishing apparatus LED arrangement patterns according to exemplary embodiments.
FIG. 3 is a schematic diagram illustrating an exemplary UV light exposure and finishing system that is configured to apply the UVA post exposure and conduct UVC light finishing to a photopolymer plate according to one exemplary embodiment.
FIG. 4 is a schematic diagram illustrating an exemplary UV light exposure and finishing system that is configured to apply the UVA post exposure and conduct UVC light finishing to a photopolymer plate according to one exemplary embodiment.
FIG. 5 is a schematic diagram illustrating an exemplary UV light exposure and finishing system that is configured to apply the UVA post exposure and conduct UVC light finishing on a photopolymer plate according to one exemplary embodiment.
FIG. 6 is a schematic diagram illustrating yet another embodiment of a UV light exposure and finishing system that is configured to apply the UVA post exposure and conduct UVC light finishing to a photopolymer plate.
FIG. 7 is a schematic diagram illustrating yet another embodiment of a UV light exposure and finishing system that is configured to apply the UVA post exposure and conduct UVC light finishing to a photopolymer plate.
FIG. 8A schematically illustrates an exemplary portion of a finishing unit comprising a plurality of drawers in a housing; and FIG. 8B schematically illustrates a cross section taken an across line 8B-8B of a drawer in FIG. 8A.
FIG. 9 is a simplified block diagram schematically showing another embodiment of an exemplary UV light exposure and finishing system, integrated with a thermal processing system.
FIG. 10 is a simplified block diagram schematically showing another embodiment of an exemplary UV light exposure and finishing system.

### DETAILED DESCRIPTION OF THE INVENTION

The invention is applicable to digital flexography, digital letterpress printing, and other digital printing plates, as well as polymer sleeves and polymer coated printing cylinders.

Exemplary embodiments regarding the devices, systems and methods as described herein, generally relate to optimizing surface properties of a printing plate during a process of manufacturing the printing plate from a photopolymer precursor. The optimization of the surface properties of the printing plate is executed by usage of UVC and UVA LEDs instead of fluorescent tubes for all light exposures (including backside exposure, frontside exposure and post exposure) and light finishing process steps in the manufacturing process. As a result of the optimization, the surface properties of the printing plate are improved.

While UV LEDs are still more expensive than UV fluorescent tubes, replacing fluorescent tubes with LEDs offers numerous technical and environmental benefits, which include, but are not limited to, higher energy efficiency, higher irradiance levels, better abilities to guide and concentrate the light to the locations where it is needed, less maintenance, less waste generation due to longer lifetime and complete avoidance of the mercury in products.

### Exemplary Embodiments

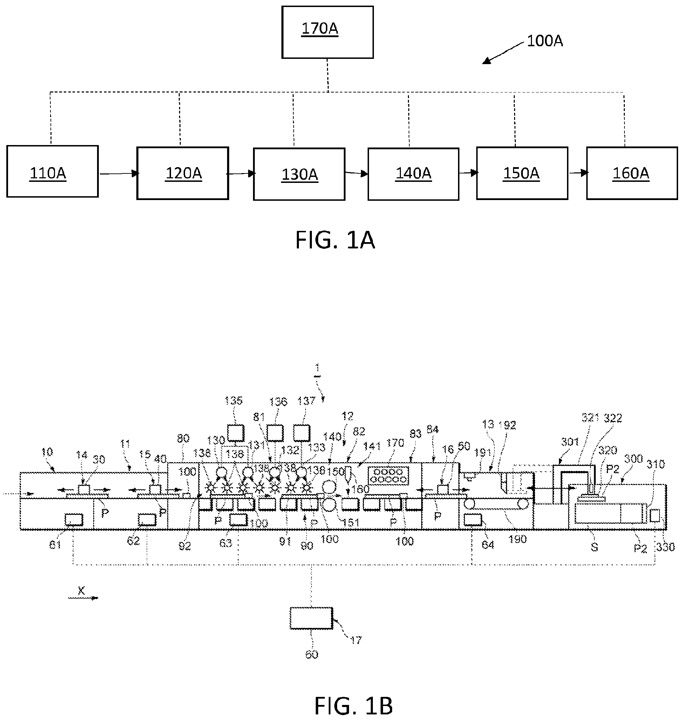

Referring now to the figures, Fig. 1A schematically illustrates a workflow 100A of creating a printing plate from a photopolymer precursor using a plurality of process machines including a finishing apparatus 130A according to one exemplary embodiment. Each of the plurality of process machines 110A-160A is configured to perform one or more process steps in the workflow of creating the printing plate from the photopolymer precursor. All of the process machines 110A-160A are controlled by a central control computer 170A. Although a process for making a flexographic printing plate is described here in detail, it should be understood that the process and systems as described herein may be applicable to the manufacture of any type of printing plate from any type of photo curable precursor, and the invention is not limited to any particular plate making technology.

Exemplary steps in this workflow may include a main UV exposure step performed by a UV exposure system 110A (which may include back side exposure and front side exposure), a post-exposure processing step to remove uncured polymer portions of the partially processed photopolymer precursor, performed by a thermal plate processor, a solvent-based plate processor, or a water-based plate processor 120A, a finishing step of curing remaining uncured portions of polymer and detacking (removing stickiness from) the photopolymer precursor performed by a finishing apparatus 130A, thereby creating a fully processed printing plate. An optional cutting step of cutting the printing plate may be performed by a cutting apparatus 140A, an optional mounting step comprising mounting one or more cut portions of the printing plate onto a substrate with a mounting apparatus 150A, and then the printing step is performed (e.g. in a flexo process) with a printing press 160A. Additional steps may also be included in the workflow at the beginning or end, and interposed between any of the steps specifically depicted e.g. exposing the photopolymer plate from the back side with UVA radiation.

For example, an imaging step typically precedes the main UV exposure step 110A, and an ordering step typically precedes the imaging step, and a storage step follows the printing step 160A. The blocks of FIG. 1A associated with each processing step are exemplary only, and a single machine may perform steps related to multiple blocks, or multiple machines may together perform the steps illustrated in a single block. Some steps depicted may be optional.

In this exemplary embodiment, the imaging step may include processing image information, using an image processor, at a certain screen resolution to obtain an image file, and then using the image processor, combining the image file with other image files to create an imaging job that covers a full photopolymer plate format. The imaging step may further include imaging the image files onto a Laser Ablated Mask (LAMs) layer on top of the photopolymer plate, by any of various methods known in the art, thereby creating a mask on top of the photopolymer plate.

The main UV exposure step, performed by the UV exposure system 110A, may include applying the back side exposure by curing the rear side of the photopolymer plate, with a UV light exposure unit of the UV exposure system 110A, to build a floor of polymer, and applying the front side exposure by curing the photopolymer plate through the mask on the top of the photopolymer plate, with the UV light exposure unit of the UV exposure system 110A. The UV light exposure unit includes a plurality of UVA LEDs that are arrayed in a predetermined pattern/module.

The thermal or chemical processing step, performed by the thermal or chemical processing apparatus 120A, may include conducting a thermal or chemical processing to remove non-cured polymer portions from the photopolymer plate.

Optionally, a drying process may be performed to dry the photopolymer plate to remove solvent (typically not performed when using a thermal process for removing uncured polymer).

The finishing step, performed by the finishing apparatus 130A, may include a post-exposure process for complete curing of all non-cured polymer portions from the photopolymer plate using UVA radiation from UVA LEDs, and a light finishing process for detacking (removing stickiness from the photopolymer plate) using UVC radiation from UVC LEDs. In general, at this step, the photopolymer precursor is now in a form that is ready for receiving ink for printing and will be referred to as a printing plate in subsequent steps.

Optionally, the cutting step, performed by the cutting apparatus 140A, may include cutting the printing plate into patches on a xy-cutting table so as to separating different image files, mounting one or more cut patches onto a substrate on a printing press cylinder with the mounting apparatus 150A. Each cut patch of the printing plate may embody one or more image files.

The printing step in the flexo process, performed by the printer 160A, may include printing physical images on the print-receiving substrate using the printing plate in a printing press. The printing step may also include cleaning ink from the printing plate, removing the printing plate from the press, and storing it for future use, such as a reprinting job.

FIG. 1B schematically illustrates an exemplary processing system installation 1 processing plates P as they move through an exposure process. Processing system installation 1 includes an imager 10 that performs laser imaging on a LAMS layer of plate P, an exposure unit 11 that exposes the imaged plate P, a developer 12 that develops (i.e. removes uncured polymer from) plate P that has been exposed, a plate cutting device 13 that cuts the developed plate P. A first transport device 14 transports the imaged plate P from the imager 10 to the exposure device 11. A second transfer device 15 conveys the cured plate P to the developer 12 and a third transport device 16 transports the developed plate P from the developing apparatus 12 to the plate cutting unit 13. Processing system 1 further includes a control device 17 that controls a series of plate making processes performed by the imager 10, the exposure unit 11, the developer 12, and the plate cutting unit 13.

The imager 10, the exposure unit 11, the developer 12, and the plate cutting unit 13 may be arranged in a straight line and are continuously connected in one direction. As depicted in FIG. 1B, the direction in which the imager 10, the exposure unit 11, the developer 12, and the plate cutting unit 13 of the processing system installation 1 are arranged sequentially (from left to right in FIG. 1B) is the "transportation direction X". The imager 10 has an inlet side and the plate cutting unit 13 has an exit side. The lateral direction that forms a right angle with respect to the transport direction X of the processing system installation 1 defines the "width direction".

An exemplary imager 10 may include an operation table, a rotating drum having clamps, and a laser irradiation unit (not shown), and may be configured such that the plate P is retained on the drum with clamps. An infrared sensitive layer covering the photosensitive resin layer of the plate P is irradiated by a laser beam to remove portions of the infrared sensitive layer to form a mask. The imager 10 may be configured to automatically load and unload the plate from the imaging drum.

Exposure unit 11 may include an exposure table, a front exposure unit that irradiates ultraviolet rays through the imaged mask of the plate P to form printing structures in relief on the plate, and a back exposure unit that irradiates ultraviolet exposure to cure a floor layer of the photosensitive resin layer through a back surface support layer of the plate P. Each of the main exposure unit and the back exposure unit preferably include UV-LED radiation sources having an emission wavelength in the UVA region. The exposure unit may be configured to perform exposure while the plate is moving in the transport direction X. The exposure may be sequentially performed first by the back exposure unit, and then by the front exposure unit. The desired exposure to cure the photosensitive resin layer may be dictated by the type and thickness of the plate P, and relative movement speeds of the exposure units and the number of exposures may also thus be controlled by the type and thickness of the plate P.

The developer 12 is configured to remove an uncured photopolymer using a developing solution, drying the developed plate P, and post-exposing the dried plate P. The imager 10, the exposure unit 11 and the plate cutting unit 13 typically process the plate P one by one, whereas the developer 12 may process and transport a plurality of plates P continuously at the same time.

The plate cutting unit 13 is configured to cut the developed plate P, into a desired shape, a desired size, and/or a desired number.

First transport device 14 may include a vacuum gripper arm 30 that moves in the transport direction X, so that the imaged plate P is gripped by the vacuum gripper arm 30 and transported to the exposure device 11.

The second transfer device 15 may include a vacuum gripper arm 40 that moves in the transfer direction X, so that the exposed plate P is gripped by vacuum gripper arm 40 and transferred to the developer12. The first transfer device 14 and the second transfer device 15 may be the same device or separate devices.

The third transfer device 16 may include a vacuum gripper arm 50 that moves in the transfer direction X, so that the plate P developed by the developing device 12 is gripped by the vacuum gripper 50 and transferred to the plate cutting device 13.

The control device 17 may include a system control unit 60 configured to control the entire plate making system having a plurality of devices, and device control units 61, 62, 63, 64 provided in each of the imager 10, the exposure unit 11, the developer 12 and the plate cutting unit 13 so as to control each of the foregoing components. The system control unit 60 and the component control units 61, 62, 64, 64 may be configured as a computer in an integrated manner, so that the computer is able to control each of components 10, 11, 12, 13 and the transfer devices 14, 15, 16 by executing with a processor, such as a central processing unit (CPU) programs stored in a memory, and to control a series of plate making processes of the plate P.

### Structure of the Developer

The developer 12 may include an import unit 80, a developing unit 81, a drying unit 82, a post-exposure unit 83, and an export unit 84, which are linearly oriented from the inlet to the outlet (transport direction X). Also, the developer 12 may further include a transport device 90 to transport the plate P.

Transport device 90 may be configured to transport plate P from the exposure unit 11 to the developer import unit 80, to the developing unit 81, the drying unit 82, the post-exposure unit 83, and the export unit 84 at a constant speed. In one embodiment, the transfer device 90 may include a transfer path 91 on which the plate P is placed and transferred, and a transfer mechanism 92 that holds and transfers the plate P along the transfer path 91. The transport path 91 may extend linearly in the transport direction X from the import unit 80 of the developer 12 to the export unit 84. The transfer mechanism 92 may include a plurality of plate holders 100 that are configured to hold and transfer the plate P.

The plate holder 100 is configured to have an elongated shape that is long in the width direction of the processing system installation 1. The plate holder 100 may include a plurality of pins (not shown), as are known in the art, arranged in the width direction of the processing system installation 1 so as to retain the plate P. The plate holder 100 may be attached to a drive device (not shown) such that the drive device can move the plate holder 100 from the import unit 80 to the export unit 84 of the developerv12 at a constant speed. Also, the plate holder 100 and the plate P may be configured to be relatively movable vertically in relation to a mounting surface (not shown) of the plate P at the import unit 80 and the export unit 84. For example, at the import unit 80, the plate P is held by inserting the pins of the plate holder 100 into respective insertion holes (not shown) of the plate P from below, or by inserting the plate P onto the pins of the plate holder 100 from above. At the export unit 84, the plate P is separated by pulling out the pins of the plate holder 100 from the insertion holes of the plate P, or by pulling out the plate P from the plate holder 100. The plate holder is not limited to a leader that is attached using pins, but may include a leader attached by any method known in the art, including adhesively.

As shown in FIG. 1B, the developing unit 81 may primarily use an aqueous developer as a solvent. The aqueous developer may be a mixture of at least a developer stock solution comprising a surfactant and water. An alkaline compound or the like may be further added to the aqueous developer. The developing unit 81 may include a plurality of, for example, three developing solution supply units 130, 131, 132 and a rinse liquid supply unit 133. The developer supply units 130, 131, 132 and the rinse liquid supply unit 133 may be provided side by side sequentially in the transport direction X along the transport path 91. The developer supply units 130, 131, 132 are configured to discharge the developer supplied from developer supply sources 135 and 136 to the plate P moving on the transport path 91. In one embodiment, the developer supply units 130 and 131 discharge a developer in which a used developer and an unused new developer are mixed, and the developer supply unit 132 discharges a new unused developer. Developer used in the developing unit 81 may be collected and reused. In aqueous systems, the rinse liquid supply unit 133 may discharge the rinse liquid, such as water supplied from a rinse liquid supply source 137, to the plate P moving on the transport path 91.

The developing unit 81 may include a plurality of brushes 138 arranged in the transport direction X along the transport path 91. Each brush 138 is configured to come into contact with a surface of the plate P moving on the transport path 91 so as to remove uncured polymer from the surface of the plate P.

The drying unit 82 may include a wiping unit 140 and a blower unit 141, which are arranged in the transport direction X sequentially. The wiping unit 140 may include rollers 150 and 151 on the upper and lower sides, so that the plate P can pass between the rollers 150 and 151 to wipe off the liquid adhering to the surface of the plate P. The blower unit 141 may include a blower knife 160, which is configured to blow air onto the surface of the plate P thereby removing the liquid on the plate P.

The post-exposure unit 83 may include an exposure lamp 170 that is provided with two types of lamps, a UVA exposure lamp and a UVC exposure lamp, so that the exposure lamp 170 can irradiate the plate P with ultraviolet light in the UVA and UVC regions, thereby post-exposing the plate P.

### Structure of Plate Cutting Unit

The plate cutting unit 13 may include a conveyor 190 that moves the plate P carried in from the developer 12 by the third transport device 16 in the transport direction X, a camera 191 that captures the plate P for positioning the plate P, and a cutter 192 that cuts the plate P.

### Structure of Control Device

Control system 17 may be configured to manage a series of plate making processes and to mark the imaged plates with registration indicia. That is, the control device 17 may instruct imager 10 to include registration indicia on the plate, which registration indicia are then identified by the cutting device to ensure the correct placement of the cuts is performed by the plate cutting unit 13. The control device 17 may include the control units 60, 61, 62, 63, 64, a memory, an operation unit, a display, a speaker, a storage unit, and a communication unit.

Next, an example of a plate-making method of the plate P using the processing system installation 1 configured as described above will be described.

### Plate-Making Process

First, the plate P is transported into the imager 10 of the processing system installation 1 shown in FIG. 1B, and a laser imaging is performed. Next, the imaged plate P is transported to the exposure device 11 by the first transport device 14, and is subjected to exposure to actinic radiation. The exposed plate P is carried into the import unit 80 of the developer 12 by the second transport device 15. When the laser imaging process of one plate P is completed in the drawing apparatus 10, and the plate P is conveyed to the exposure unit 11, the next plate P is fed into the imager 10. As described above, in this plate-making process, a plurality of plates P are continuously and sequentially processed.

The plate P carried into the import unit 80 of the developer 12 is held by the plate holder 100, and then is conveyed at a constant speed by the plate holder 100 along the transport path 91 sequentially through the developing unit 81, the drying unit 82, the post-exposure unit 83 and the export unit 84. In the developing unit 81, developing solution is supplied to the plate P from the developing solution supply units 130, 131, 132, and then the rinsing liquid is supplied from the rinsing liquid supply unit 133 to the plate P. The brush 138 comes into contact with the plate P together with the supply of the developing solution and the rinsing solution, and the brush 138 brushes off and removes unnecessary substances on the surface of the plate P.

In the drying unit 82, the plate P is first conveyed to the wiping unit 140, passes through the rollers 150 and 151, and the liquid on the plate P is wiped off. Next, the plate P is conveyed to the blower unit 141, and the liquid on the plate P is blown off and removed by the air from the blower knife 160.

In the post-exposure unit 83, the plate P is irradiated with ultraviolet light that emits UVA and UVC regions from the exposure lamp 170. Subsequently, plate P is transported to the export unit 84.

The plate P transported to the export unit 84 is transported to the plate cutting unit 13 by the third transport device 16 after the plate holder 100 is removed. In the plate cutting unit 13, the plate P is arranged at a predetermined position by the conveyor 190, and is imaged by the camera 191. Then, the plate P is cut by the cutter 192. Cut portions of plate P are sent to the outlet side by the conveyor 190, and are ready to be carried out from the plate-cutting unit 13. The plate making processes are controlled by the control device 17. The plate until the plate is cut may be referred to as a precursor plate, and the plate after the plate is cut may be referred to as a printing plate.

In the processing system installation 1, as shown in FIG. 1B, may further include a mounting device 300 on which is disposed a carrier sleeve S on which a cut plate portion P2 cut by the plate-cutting device 13 is attached with a cushion tape. A fourth transporting device 301 transports the cut plate portion P2 to the mounting device 300.

In the processing system installation 1, the imager 10, the exposure unit 11, the developer 12, the plate cutting unit 13, the first transfer device 14, the second transfer device 15, the third transfer device 16, the fourth transfer device 301 and the mounting device 300 may be provided as an integral unit. The imager 10, the exposure unit 11, the developer 12, the plate cutting unit 13, and the mounting device 300 may be arranged in a straight line and continuously connected. In other embodiments, one or more of the imager 10, the exposure unit 11, the developer 12, the plate cutting unit 13 and the mounting device 300 may be arranged at one or more predetermined angles relative to one another.

The mounting device 300 may be a device for mounting the cut plate portion P2 to the carrier sleeve S to which the cushion tape is attached. The mounting device 300 may include a holding portion 310 for holding the carrier sleeve S on which the plate portion P2 is mounted.

The fourth transfer device 301 may include a robot arm 321 having a suction pad 320. The fourth transfer device 301 is arranged between the mounting unit 300 and the plate cutting device 13, so that the robot arm 321 grips and holds the plate portion P2 with the suction pad 320, thereby transporting the plate P2 to the mounting device 300. The fourth transfer device 301 is further configured to convey the held plate portion P2 onto the carrier sleeve S disposed on the mounting device 300 and directly attach the plate P2 to the sleeve S.

The robot arm 321 may preferably include at least two suction pads in order to convey the plate portion P2 to an accurate position. A hose connected to a vacuum source is connected to the suction pads. The plate portion P2 is mounted on the robot arm 321 by pressing the suction pads against the plate portion P2 to remove air from between the suction pads and the plate portion P2, and thus the plate P2 is transported in that state. Further, after moving the plate P2 to a predetermined correct position, suction on the plate P2 can be released by injecting positive pressure into the suction pads. There is no limit to the material and shape of the suction pads, but for flexibility and scratch-resistance, an elastomer-based material is preferable, such as polybutadiene rubber, polyacrylonitrile-butadiene rubber, polyurethane, silicone, fluoroelastomers, and the like. The size of the suction pad may also be arbitrarily selected according to the expected size and thickness of the plate portion P2.

The fourth transfer device 301 transfers an end of the plate P2 to a predetermined position on the sleeve S in the mounting device 300, and attaches the end of the plate P2 to the carrier sleeve S. Then the plate P2 can be attached to the carrier sleeve S by separating the plate P2 from the suction pad 320 while rotating the sleeve S. Furthermore, in order to attach the plate P2 to the carrier sleeve S with uniform tension, the plate P2 may be sandwiched between the carrier sleeve S and a roller that rotates separately from the carrier sleeve S.

The fourth transfer device 301 may include a camera 322 as a reading device for reading the position information of the plate P2. The position information of the plate P2 may include, but not limited to, information on the position and angle of the plate P2 with respect to the coordinate system of the fourth transfer device 301. The camera 322 may be provided on the main body of the mounting unit 300 instead of the fourth transport device 301.

The control device 17 controls the plate making processes of the plate precursor P and the printing plate P2 performed by the imager 10, the exposure unit 11, the developer 12, the plate cutting unit 13, and the mounting unit 300.

The control device 17 may further include a device control unit 330 that controls the mounting unit 300 and which is provided in the mounting unit 300. Also, the control device 17 may be configured to manage a series of plate making processes so that the mounting unit 300 can place the desired registration marks on the plate precursor P on which the imaging is performed and the printing plate P2 on which the plate is cut. That is, the control device 17 manages the placement of registration marks on plate P by the imager 10 and shares information with the mounting process performed by the mounting unit 300, thereby ensuring the plate P2 is mounted at a predetermined position on the sleeve S.

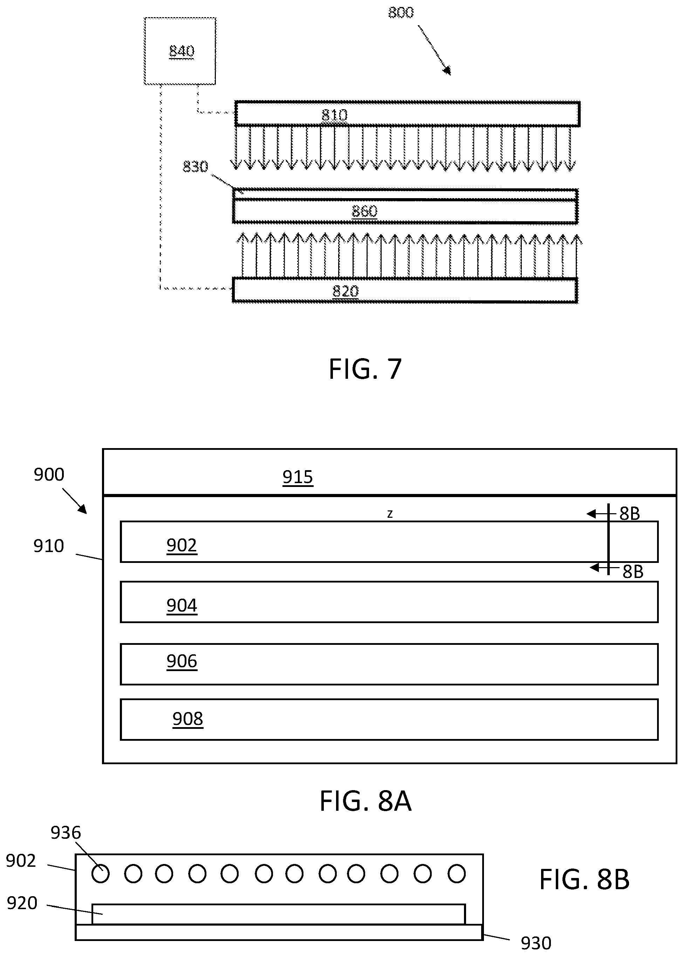

FIG. 8A schematically illustrates an exemplary portion of a finishing unit 900, comprising a plurality of drawers 902, 904, 906, 908 in a housing 910. At least one of the drawers is arranged with UVA and UVC LEDs. Each drawer, as shown in the cross section of FIG. 8B taken across line 8B-8B of drawer 902, comprises a substrate 930 for receiving a photopolymer plate 920 and a plurality of UV sources 936. The plurality of UV sources 936 may be arranged in a pattern, as further discussed below. At least one of the drawers 904, 906 and 908 may also have a heat source (not shown) to serve as a dryer to perform the drying step, so that the finishing unit 900 becomes a finishing/drying unit. The finishing/drying unit 900 may also be combined with an exposure unit 915, typically located above the finishing/drying drawers. The drying drawer may, in part, reuse heat recovered from the waste heat generated by the light sources 936 used for post exposure and light finishing.

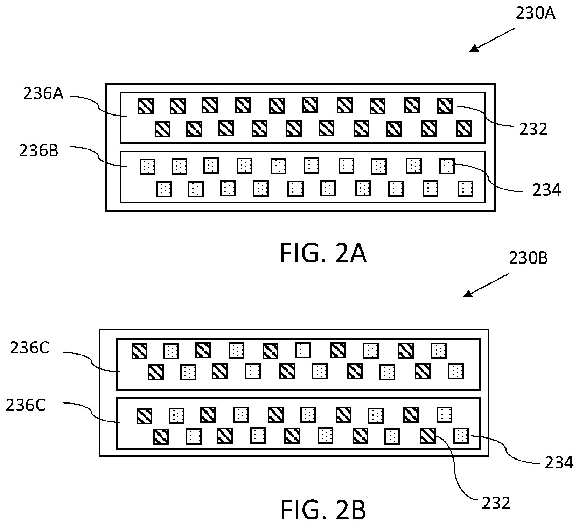

FIGS. 2A and 2B schematically illustrate exemplary post exposure and finishing apparatus LED arrangement patterns 230A and 230B according to exemplary embodiments. As shown in FIG. 2A, in one arrangement 230A, an array 236A of UVA LEDs 232 and an array 236B of UVC LEDs 234 are each disposed on separate circuit boards in a parallel arrangement. While only two rows of point source LEDs 232, 234 are shown in each array 236A, 236B, respectively, for illustration, it should be understood that each array may comprise more than two rows of the relevant type of LED. It should also be understood that the arrays of LEDs may include any number of species of LEDs, each species having a different wavelength. For example, more than one species in the UVA range or UVC range may be provided, as well as LEDs in the UVB range. The number of species, wavelengths, and arrangements of the different species may include any combination or permutation, without limitation. Additionally, although only one array of UVA LEDs 232 and only one array of UVC LEDs 234 are shown, it should be understood that more than one of each array may be present, depending upon the application. For example, in a drawer embodiment (e.g. as depicted in FIGS. 8A and 8B and described in more detail herein), a plurality of arrays of each type of LED may be provided. In another drawer embodiment, each array of LEDs may be configured as a replacement source suitable for replacing a fluorescent bulb in a prior art drawer. Each such discrete source may be referred to herein as a "lamp." Such replacement lamp embodiments may be configured as is shown and described in PCT International Publication No. WO 2021/038039 A1, titled UV LED RADIATION SOURCES FOR USE IN PHOTOPOLYMER EXPOSURE, assigned to the common assignee of this application, and incorporated by reference herein for all purposes. Applications of the subject arrangement are not limited to the drawer embodiments, however, as discussed herein further. Likewise, applications of the subject invention are not limited to configurations for replacing fluorescent bulbs, or to configurations with a plurality of discrete sources. In this arrangement, the array 236A of UVA LEDs 232 may be referred to as a first set of LEDs, and the array 236B of UVC LEDs 134 may be referred to as a second set of LEDs. The first set of LEDs may be accommodated in one lamp (e.g. a structure comprising the plurality of LEDs), and the second set of LEDs may be accommodated in a different lamp.

As shown in FIG. 2B, in another arrangement 230B, a single array (or lamp) 236C may comprise a mix of both UVA LEDs 232 and UVC LEDs 234. While only two rows of point source LEDs 232 and 234 are shown in each array, for illustration, it should be understood that each array may comprise more than two rows of mixed UVA and UVC LEDs. Additionally, although only two arrays 236C are shown, it should be understood that more than one array may be present, depending upon the application. For example, in a drawer embodiment, a plurality of arrays 236C may be provided, and each of the plurality of arrays 236C may be configured in as replacement bulb configuration. In this arrangement, among the mixed UVA and UVC LEDs, the first set of LEDs, which represents the UVA LEDs, and the second set of LEDs, which represents the UVC LEDs, may be accommodated in a single lamp.

The radiation intensities and the radiation time periods of these LEDs 232 and 234 may be controlled by the central control computer 170A. The arrangement of the UVA LEDs 232 and the UVC LEDs 234 may be any patterns/modules that are suitable for optimizing the post exposure process and the light finishing process. For example, although shown in a staggered pattern (wherein the LEDs of one row align on center with the spaces between LEDs in an adjacent row), a columnar pattern (wherein the LEDs of one column align on center with the LEDs of adjacent columns) may also be provided. Patterns of single species (i.e. all UVA or all UVC) or multi-species (i.e. a mix of UVA and UVC or any combination of different wavelengths one or more of the UVC, UVB, or UVA ranges) LEDs may be arranged and controlled in any of the patterns shown and described in PCT International Publication No. WO 2020/216948 A1, titled APPARATUS AND METHOD FOR EXPOSING PRINTING PLATES USING LIGHT EMITTING DIODES, assigned to the common assignee of this application, and incorporated by reference herein for all purposes.

Moreover, under any patterns/modules of LED arrangement, the UVA LEDs 232 and UVC LEDs 234 may be turned on/off simultaneously. In other embodiments, the UVA LEDs and UVC LEDs may be turned on simultaneously, and one turned off after a predetermined interval. In still other embodiments, the UVA LEDs and UVC LEDs may be simply turned on/off separately. Although not limited to any particular irradiance values or application duration, typical UVA irradiance may be in a range of between 16 and 20 mW/cm² applied for a duration of between 4 -10 minutes, depending upon plate thickness. UVC irradiance may be in a range of between 7 and 11 mW/cm and applied for a duration of between 1 and 6 minutes, with energy densities in the range of 0.5-3.5 J/cm².

In the post exposure process, the photopolymer plate is processed (e.g. thermally or by water or hydrocarbon solvent washing processes) to remove uncured portions/areas of the polymer. When subjected to a washing process, the photopolymer plate may then be rinsed and dried by blowing hot air onto the photopolymer plate, by using an infrared heater, or by placing the photopolymer plate into a post exposure oven. The infrared heater and the post exposure oven may be arranged in different drawers of the finishing unit 900 (in FIG. 8A), or actinic radiation and heat exposure may be provided in a single drawer. Then the photopolymer plate is subjected to the UVA light radiation for complete curing of all remaining polymer portions of the photopolymer plate using the UVA LEDs to increase the plate strength of the photopolymer plate.

The UVC light finishing process may be conducted subsequent to the UVA post exposure. In the UVC light finishing, the UVC radiation from the UVC LEDs 234 is applied to detack (remove stickiness from) the photopolymer plate. Specifically, after the UVA post exposure, the photopolymer plate is exposed to high energy (e.g. in a range between 7 - 11 mW/cm² up to 250 -300 mW/cm²) UVC light from the UVC LEDs 234, which removes any residual tackiness and hardens the exposed surface, making it resistant to alcohol-based solvents, thereby improving the surface properties (including surface tension) of a resulting printing plate. Also, with increased radiation from the UVC LEDs 234, the surface tension of the printing plate can be modified, thereby improving ink transferring properties of the printing plate.

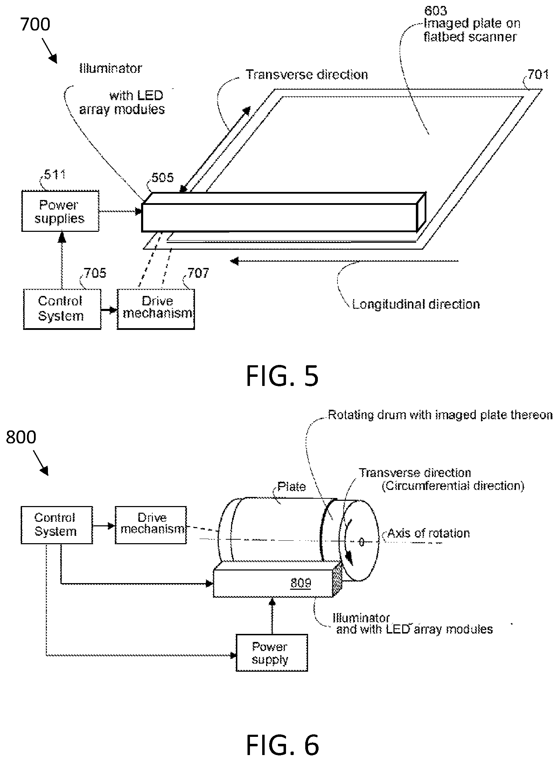

In this exemplary embodiment, the post-exposure in the finishing apparatus 130A may be maintained for a time period. The time period may be predetermined depending on a type of the polymer and/or output power of the LEDs. For example, it is known that 254 nm wavelength light finishing tubes having an irradiance of 10 mW/cm² can cure ACE polymer during a cure time of between 2 and 6 Minutes, which corresponds to ~1.2 - 3.6 J/cm². Use of a light source that provides 200 mW/cm² (assuming the LED wavelength has the same efficiency as the 254 nm tube), the curing time for a single spot in the polymer may decrease from 2 to 6 Minutes to 6 to 18 seconds, if all of the energy is applied in a single exposure step. The total energy may be applied in a plurality of exposure steps, however, wherein each step contributes a part of the total energy. This can be realized e.g. with several drum rotations (of the embodiment depicted in FIG.6), but the same principle may be implemented in flatbed embodiments with multiple carriage passes. Likewise, a 20 mW/cm² post-exposure treatment of 10 minutes contributes 12J/cm² post-exposure energy, so if the UVA Source provides 200 mW/cm², the treatment time to reach 12J7cm² is 1 minute, which may also be broken down into multiple post-exposure steps (e.g. 10 x 6 seconds).

Each exposure step may be referred to as an "exposure cycle," and each exposure cycle defines an "energy contribution." Some embodiments may include executing two or more consecutive exposure cycles. In some embodiments, a first set of LEDs may provide post exposure radiation for a first exposure time in a first exposure step, and a second set of LEDs may provide finishing radiation for a second exposure time in a second exposure step. The first and second exposure steps may be performed simultaneously or in alternation. The energy contribution per exposure cycle may be constant, may increase over time, or may decrease over time. In embodiments, the energy contribution per exposure cycle may increase over time for one of the first set of LEDs or the second set of LEDs and decrease over time for the other of first set of LEDs or the second set of LEDs.

The invention is not limited to any particular irradiance or duration, or number of post-exposure steps, however. The predetermined post-exposure treatment time period may be adjustable by the central controlling computer 170A to optimize the post exposure and light finishing. Subsequent to the light finishing, the engraved photopolymer plate becomes a printing plate, which may be ready for cutting and/or mounting in a flexographic printing press.

As will be described in detail below, unlike the embodiments described above, in some exemplary embodiments, the finishing apparatus 130A may be configured as a standalone system that includes its own control system and is configured to apply the UVA post exposure and conduct the light finishing processes. In some other embodiments, the image processor in the imaging step or the UV exposure system 110A (in FIG. 1A) may be configured to have a separate UVA/UVC compartment, which provides additional functionalities of applying the UVA post exposure using UVA LEDs 232 and conducting the UVC light finishing using UVC LEDs 234. Alternatively, the thermal or chemical processing apparatus 120A may be configured to have a separate UVA/UVC compartment, which provides additional functionalities of applying the UVA post exposure using UVA LEDs 232 and conducting the UVC light finishing using UVC LEDs 234. While typically the post exposure and the light finishing process steps are performed after the thermal or chemical processing step, in some applications, a UVC pre-curing step may be applied through the mask prior to removal of the uncured polymer, to make the printing surface more resilient against the washing or thermal treatment processing steps. Moreover, the separate UVA/UVC compartment may be arranged into a plate drying unit (drying oven) for the drying process, where the UVA LEDs 232 and UVC LEDs 234 replace the fluorescent tubes.

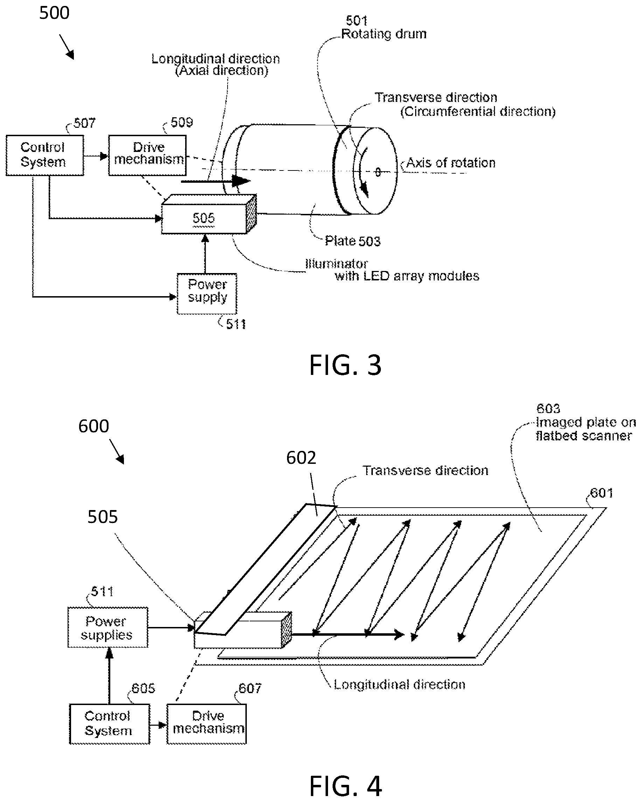

FIG. 3 is a simplified block diagram of one embodiment of an exemplary UV light exposure and finishing system 500 that is configured to apply the UVA post exposure and conduct UVC light finishing to a photopolymer plate.

As shown in FIG. 3, the UV light exposure and finishing system 500 includes a rotating drum 501 having a drum axis, a photopolymer plate 503, a UV light exposure unit 505, and a control system 507. In this embodiment, the photopolymer plate 503 is mounted on the rotating drum 501 after the main exposure (including the back exposure and the front exposure) processes are completed. The UV light exposure unit 505 may have an arrangement of both UVA LEDs 232 and the UVC LEDs 234, such as in one of the arrangements depicted in FIGS. 2A or 2B. These LEDs 232 and 234 may arrayed in a predetermined pattern/module to make UV radiation that is suitable for optimizing the post exposure and the light finish processes. In such an embodiment, rather than being configured as a replacement for a fluorescent tube, the LEDs 232 and 234 may be configured on a single or multiple circuit boards in an arrangement that is suitable for the arrangement of the system.

In this embodiment, as shown in FIG. 3, the UV light and finishing system 500 may function as a standalone system such that the drive mechanism 509 produces relative motion between the UV light exposure unit 505 and the photopolymer plate 503 during the post exposure and light finishing processes by at least rotating the drum 501 around the drum axis. On the other hand, the UV light exposure unit 505 may move parallel to the drum axis in the longitudinal direction (axial direction). The control system 507 is connected to the drive mechanism 509, a power supply 511, and the UV light exposure unit 505 that is powered by the power supply 511.

The control system 507 is coupled to and configured to control the drive mechanism 509 and the UV light exposure unit 505. At any time during operation, the UV light exposure unit 505 illuminates a relatively small portion of the full photopolymer plate 503 in the transverse direction of rotation of the drum 501. The light intensity from the UV light exposure unit 505 is applied repeatedly and periodically to any region according to a rotational speed of the drum 501.

The rotational speed of the drum 501 and the moving speed of the UV light exposure unit 505 may be determined based on the plate material, the intensities of the UV light radiations (including UVA light and UVC light), and on the proportion of the photopolymer plate that is illuminated at any one time.

FIG. 6 schematically shows yet another embodiment of a UV light exposure and finishing system 800 that is configured to apply the UVA post exposure and conduct UVC light finishing to a photopolymer plate. As shown in FIG. 6, the UV light exposure and finishing system 800 includes a UV light exposure unit 809 that is configured to perform the post exposure and the light finishing to the photopolymer plate. In this embodiment, the UV light exposure unit 809 extends to cover one dimension of the photopolymer plate, which is the longitudinal direction in this exemplary embodiment. Relative motion in only one direction is then necessary, in this example, the circumferential, i.e., transverse direction. The control system is coupled to the drive mechanism and arranged to control the speed of rotation. The drive mechanism together with the control system is such that the speed of rotation can be controlled for optimizing the post exposure and light finishing process. An alternating mode of having several transitions between UVA and UVC may be suitable for the UV light exposure and finishing system 800.

In an exemplary workflow may include subjecting the photopolymer plate to main exposure step, processing the photopolymer plate with a thermal processor, then providing a finishing UVA/UVC treatment as described herein.

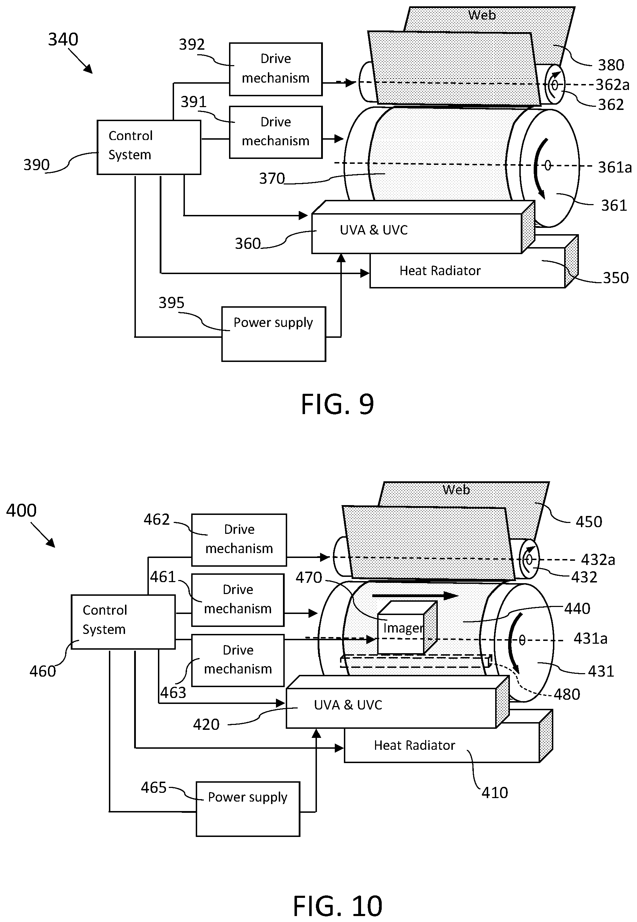

In the latter process workflow, the combined imaging/exposure/finishing unit may also comprise a thermal treatment compartment where the photopolymer plate is thermally treated to remove uncured polymer, as further described with respect to FIG. 10, below.

FIG. 4 is a simplified block diagram of another embodiment of an exemplary UV light exposure and finishing system 600 that is configured to apply the UVA post exposure and conduct UVC light finishing to a photopolymer plate.

In this embodiment, the photopolymer plate may be on a flatbed, e.g., of a flatbed scanner, also called an x-y table, and a drive mechanism is configured to produce relative motion between the UV light exposure unit and the photopolymer plate.

As shown in FIG. 4, the UV light exposure unit 505 moves above an imaged photopolymer plate 603 placed on a flatbed table 601 during the post exposure and light finishing process. The photopolymer plate 603 is post-exposed by the UV radiation from the UVA LEDs 232 of the UV light exposure unit 505, and is then detacked (light finishing) by the UV radiation from the UVC LEDs of the UV light exposure unit 505.

In this embodiment, as shown in FIG. 4, the UV light and finishing system 600 functions as a standalone system such that a control system 605 is coupled to a power supply 511 and configured to control the output power of the UV light exposure unit 505. The control system 605 also is coupled to and configured to control a drive mechanism 607 that is configured to move the UV light exposure unit 505 back and forth in a transverse direction while also moving in a longitudinal direction (e.g. on a gantry system in which the gantry 602 moves in the longitudinal direction, wherein the UV light exposure unit 505 includes a carriage (not shown) that moves back and forth along the gantry 602 in the transverse direction). The drive mechanism 607 together with the control system 605 is such that the speed of back and forth motion and repetition rate can be controlled for optimizing the post exposure and the light finishing processes. In another embodiment, the UV light exposure unit 505 may be configured to move only in the transverse direction and the photopolymer plate 603 may be configured to move in the longitudinal direction, or vice versa. In still other embodiments, the radiation source may be stationary and the photopolymer plate 603 may execute all of the movement. Although shown on a horizontal flatbed 601, it should be understood that the flatbed 601 is not limited to any specific planar orientation, and may even be vertically oriented.

FIG. 5 shows a schematic diagram of one embodiment of a UV light exposure and finishing system 700 that is configured to apply the UVA post exposure and conduct UVC light finishing on a photopolymer plate. The UV light exposure and finishing system 700 includes a flatbed 701 on which an imaged photopolymer plate 603 is post-exposed and detacked. In this embodiment, during the post exposure and light finishing processes, the UV light exposure unit 505 moves in a transverse direction. The UV light exposure unit 505 has at least one dimension that covers one full dimension of the photopolymer plate 603 (e.g. the longitudinal direction). Thus, relative movement in the transverse direction provides exposure for the full dimension of the photopolymer plate 603.

In other embodiments, such as is described in more detail in FIG. 1B, the photopolymer plate 603 may move relative to a stationary source. For example, in an embodiment in which the imaged photopolymer plate 603 moves in a longitudinal direction perpendicular to the transverse axis, such as on a conveyor, the UV light exposure unit 505 may be arranged to cover the full transverse dimension of the photopolymer plate 603. As described in more detail above with respect to FIG. 1B, such an embodiment may be coupled with an upstream water or solvent based processing system for removal of uncured polymer, followed by a drying step in a dryer, where the plate may be transferred from the dryer to the next processing station automatically, e.g. on a conveyor, using robotics, etc.

In this embodiment, as shown in FIG. 5, the UV light exposure and finishing system 700 may function as a standalone system, or may be integrated with a main exposure system, such as an Esko XPS system as is known in the art. In an integrated system, UVC sources for the finishing process may be provided in addition to the UVA exposure sources. UVA sources for the post exposure process may be the same UVA sources as used for main exposure, or may be different sources. In some embodiments, the UVC exposure may be performed immediately after the main exposure, before remove of uncured polymer portions of the photopolymer plate 603. In other embodiments, the uncured polymer portions are first removed, and then the photopolymer plate 603 is returned for finishing UVA and UVC exposure. A control system 705 is coupled to a power supply 511 and configured to control the output of the UV light exposure unit 505. The control system 705 also is coupled to and configured to control a drive mechanism 707 that is configured to move the UV light exposure unit 505 and/or the photopolymer plate 603 in a manner controllable to achieve an optimization of the post exposure finishing operation (and the main exposure, in units in which the main exposure and finishing exposure are integrated) to the photopolymer plate 603.

In FIGS. 3 to 6, some elements such as the UV light exposure units have different reference numbers but may be similar or identical in structure. Similarly the photopolymer plate and other shown elements may be similar or identical even if different reference numerals are used.

FIG. 7 shows a simple drawing of yet another embodiment of a UV light exposure and finishing system 800 that is configured to apply the UVA post exposure and conduct UVC light finishing to a photopolymer plate. In this embodiment, the UVA post exposure and the UVC Light finishing may be realized with a stationary UV exposure unit 810 and a stationary photopolymer plate 830 mounted on a plate substrate 860, such that the arrangement of the UVA and UVC LEDs cover both lateral dimensions of the photopolymer plate 830. In the embodiment depicted in FIG. 7, the plate substrate 860 may be transparent to the UVA and UVC radiation, such that an exposure unit 820 disposed beneath the plate substrate 860 may also be used for backside exposure. Although a backside exposure unit for exposing the non-printing side of a photopolymer plate may not have been depicted in other embodiments, it should be understood that a backside exposure unit may be present in all of the embodiments discussed herein. As used herein, the term "backside" refers to the non-printing side of the photopolymer plate, and the term "front side" may be used to refer to the printing side of the photopolymer plate to which ink is applied in a printing step. Notably, the finishing and detacking exposure may be provided from the front side or the back side, such as from the location of any of the front side or back side light sources as depicted in any of the figures appended hereto.

In any of the embodiments depicted herein, in the post exposure and light finishing processes, the UVA post exposure is preferably applied after all uncured polymer portions of the photopolymer plate have been removed. Likewise, the UVC light finishing for detacking (UVC curing) is also preferably applied after all uncured polymer has been removed (otherwise, the tackiness of the photopolymer plate may attract dust and lint that sticks to the photopolymer and may disturb the printing process.

FIG. 9 is simplified block diagram schematically showing another embodiment of an exemplary UV light exposure and finishing system 340, integrated with a thermal processing system.

As shown in FIG. 9, the UV light exposure and finishing system 340 may include a thermal processing apparatus, a UVA/UVC compartment 360, and a power supply 395. The thermal processing apparatus may comprise a heat radiator 350, a first rotating drum 361, a second rotating drum 362, a first drive mechanism 391, a second drive mechanism 392, and a control system 390. The UVA/UVC compartment 360 provides additional functionalities of applying the UVA post exposure using UVA LEDs and conducting the UVC light finishing using UVC LEDs.

The first rotating drum 361 has a first drum axis 361a, and the second rotating drum 362 has a second drum axis 362a. A photopolymer plate 370 is mounted on the first rotating drum 361, and an absorbant web or blotter 380 is mounted on the second rotating drum 362.

The control system 390 is coupled to the first drive mechanism 391, the second drive mechanism 392, and the power supply 395. The control system 390 controls the first drive mechanism 391 to rotate the first rotating drum 361 around the first drum axis, and the second drive mechanism 392 rotates the second rotating drum 362 around the second drum axis. The control system 390 also controls the power supply 395 so that the power supply 395 is able to simultaneously or separately turn on/off the UVA LEDs and the UVC LEDs in the UVA/UVC compartment 360.

The control system 390 is also coupled to the heat radiator 350 so as to regulate/adjust level and time of heat radiation generated by the heat radiator 350.

The second drum 362 advances web 380 into contact with the thermally treated plate to remove molten non-cured polymer portions from the photopolymer plate 370. Although schematically depicted in the drawing as located across from web 380 (to reduce clutter in the figure), heat radiator 350 may be located closer to web 380 in the rotation direction of the first rotating drum 361 (so that there is not much travel between the heat that melts the uncured polymer and the web that gathers the molten polymer). Although shown with web 380 in contact with the plate, it should be understood that drum 362 may be moveable toward or away from drum 361, such that web 380 is in contact with the plate 370 only during a thermal treatment and uncured polymer removal phase of processing.

In this embodiment, the photopolymer plate 370 may be mounted on the first rotating drum 361 after the main exposure (including the back exposure and the front exposure) processes are completed. The UVA/UVC compartment 360 may have an arrangement of both UVA LEDs and the UVC LEDs, such as in one of the arrangements depicted in FIGS. 2A or 2B. These UVA and UVC LEDs may arrayed in a predetermined pattern/module to transmit UV radiation that is suitable for optimizing the post exposure and the light finish processes. In this embodiment, rather than being configured as a replacement for a fluorescent tube, the UVA and UVC LEDs may be configured on a single or multiple circuit boards in an arrangement that is suitable for the operation of the system.

The control system 390 is also coupled to the UVA/UVC compartment 360 and is configured to regulate/adjust intensity and time of UV radiation of each of UVA and UVC LEDs.

In this embodiment, the UVA/UVC compartment 360 extends to cover one dimension of the photopolymer plate 370, which is the longitudinal direction in this exemplary embodiment. Relative motion in only one direction is then necessary, in this example, the circumferential, i.e., transverse direction. The control system 390 is coupled to the first and second drive mechanisms 391 and 392, and is configured to control the respective rotation speeds of the first and second drums 361 and 362 for optimizing the post exposure and light finishing process.

The UVA/UVC compartment 360 may be configured to have a configuration comparable to finishing apparatus 230A or 230B. The post exposure and light finishing processes may be performed after the thermal or chemical processing step.

FIG. 10 is simplified block diagram schematically showing another embodiment of an exemplary UV light exposure and finishing system 400.

As shown in FIG. 10, the UV light exposure and finishing system 400 may include a thermal processing apparatus, a UVA/UVC compartment 420, and a power supply 465. The thermal processing apparatus may comprise a heat radiator 410,, a first rotating drum 431, a second rotating drum 432, a first drive mechanism 461, a second drive mechanism 462, a third drive mechanism 463, and a control system 460. The UVA/UVC compartment 420 is configured to apply the UVA post exposure using UVA LEDs and to conduct UVC light finishing using UVC LEDs.

The first rotating drum 431 is a hollow drum having a first drum axis 431a, and the second rotating drum 432 has a second drum axis 432a. A photopolymer plate 440 is mounted on the first rotating drum 431, and an absorbent web or blotter 450 is mounted on the second rotating drum 432.

Unlike UV light exposure and finishing system 340, UV light exposure and finishing system 400 further includes imaging optics such as an imager 470 to ablate the mask with imaging information corresponding to the content to be printed. The UVA/UVC compartment 420 is configured to apply UVA main exposure (frontside exposure) to the photopolymer plate 440 after an imaging process step and prior to thermal = processing. Additionally, an UVA back exposure device 480 may be implemented inside hollow drum 431. In such an embodiment, the outer shell of the hollow drum 431 may comprise Plexiglas or any other suitably strong plastic, polymer, or even glass material transparent to UVA radiation.

The control system 460 is coupled to the first drive mechanism 461, the second drive mechanism 462, the third drive mechanism 463, and the power supply 465. The control system 460 controls the first drive mechanism 461 to rotate the first rotating drum 431 around the first drum axis, and the second drive mechanism 462 to rotate the second rotating drum 332 around the second drum axis. The control system 460 also controls the third drive mechanism 463 configured to activate the imaging system 470, and controls the power supply 465 to simultaneously or separately turn on/off the UVA LEDs and the UVC LEDs in the UVA/UVC compartment 420.

The control system 460 is also coupled to the heat radiator 410 so as to regulate/adjust level and time of heat radiation generated by the heat radiator 410 for thermal processing of the uncured polymer.

The second drum 432 advances the web 450 in touch with photopolymer plate 440 to remove molten non-cured polymer. The heat radiator 410 may be located across from the web 450 to apply the heat radiation, thereby cleaning the photopolymer plate 440. Heat radiator 410 may be located closer to web 450 in the rotation direction of the first rotating drum 431 than as depicted in the figure to reduce clutter. Likewise the back exposure device 480 may be spaced from the UVA/UVC compartment 420 an optimum distance for performing the main exposure with the back exposure leading the front exposure by a precise and optimal time delay. The back exposure device 480 may have a variable position relative to the UVA/UVC compartment to allow adjustability and optimization of the delay time at a constant drum speed and/or the drum speed may be adjusted to adjust the delay.

Thus, in this embodiment, the photopolymer plate 440 may be mounted on drum 431 and subjected to imaging, main exposure (including back and front exposure), thermal processing to remove uncured polymer, and then UVA/UVC finishing /detacking all in a single system. The UVA/UVC compartment 420 may have an arrangement of both UVA LEDs and the UVC LEDs, such as in one of the arrangements 230A or 230B depicted in FIGS. 2A or 2B, respectively. These UVA and UVC LEDs may arrayed in a predetermined pattern/module to emit UV radiation that is suitable for optimizing the post exposure and the light finish processes, as well as for conducting (UVA) front exposure. In this embodiment, rather than being configured as a replacement for a fluorescent tube, the UVA and UVC LEDs may be configured on a single or multiple circuit boards in an arrangement that is suitable for the operation of the system.

The control system 460 is also coupled to the UVA/UVC compartment 420 and configured to regulate/adjust intensity and time of UV radiation of each of UVA and UVC LEDs.

In this embodiment, the UVA/UVC compartment 420 extends to cover one dimension of the photopolymer plate 440, which is the longitudinal direction in this exemplary embodiment. Relative motion in only one direction is then necessary: in this example, the circumferential, i.e., transverse direction. The control system 460 is coupled to the first and second drive mechanisms 461 and 462 and is configured to control the respective rotation speeds of the first and second drums 431 and 432 for optimizing the post exposure and light finishing process.

In the exemplary embodiments described above, the UVA LEDs may be configured to emit the post exposure radiation in a UVA spectral range of 315-400 nm, preferably, 364 nm, and the UVC LEDs are configured to emit the light finishing radiation in a UVC spectral range of 245-280 nm, preferably, in a range of 270-280 nm. The UVA and UVC LEDs may be integrated in separate lamps, including at least one lamp for accommodating the UVA LEDs and at least one lamp for accommodating the UVC LEDs. Alternatively, the UVA and UVC LEDs may be arranged in one lamp in combination, such as described herein above. Any combination may be provided for optimizing the post exposure and light finishing processes, as well as optional main exposure where applicable, such as half UVA LEDs and half UVC LEDs, or 40 percent of UVA LEDs and 60 percent of UVC LEDs or vice versa.

### Advantages of Combinations of UVA and UVC LEDs

There are many benefits of using the combinations of UVA and UVC LEDs over the fluorescent tubes. In addition to longer lifetime and low environmental impact, usage of the UVA and UVC LEDS for post exposure and light finishing offers improvement of the surface properties of the printing plate.

As the LED radiation can be much more concentrated compared to radiation from a fluorescent tube, higher irradiance levels are possible. For example, the irradiance level for the UVA LEDs used in the post exposure process may be as high as 500 mW/cm², and the irradiance level for the UVC LEDs used in the light finishing process may be in a range of 250-300 mW/cm². Relatively higher irradiance allows execution of the post exposure curing in a much shorter time as compared to the conventional UVA source using the fluorescent tubes. For example, for a UVA LED source that illuminates the same plate dimensions as the conventional fluorescent tubes, an irradiance level of the UVA LEDs 10 times higher than conventional fluorescent tubes permits an exposure time of only one 10^{th} of the time the conventional fluorescent tubes need.

While some embodiments may focus on providing shorter finishing time, other embodiments may use LEDs chosen to have a similar total power as tubes. Because the nature of LEDs results in the same power being more concentrated on a smaller area, higher irradiance is achieved even with the same amount of power. This higher irradiance leads to significantly more crosslinking in the polymer network as compared to the conventional fluorescent tubes. Time saving benefits may also accrue because the post exposure and light finishing processes may be combined with the other processing steps in one system.

In combination with a high intensity UVA main exposure, such as applied for creation of flat top dots, the properties of the polymer printing plate can be improved in numerous aspects that are not possible using the conventional fluorescent tubes.

One aspect is the improvement in hardness of the polymer that may affect the printing properties of the printing plate. As the post exposure curing is applied after the mask has been removed, all portions of the photopolymer plate are cured simultaneously. This leads to stiffer support shoulders on the printing plate, which will print small details like thin lines or individual free-standing dots more precisely.

Another aspect is improvement of the surface properties of the printing plate by the UVC light finishing after the UVA post exposure. Specifically, the intensity of the UVC light modifies the surface properties of the printing plate with respect to ink transferring properties. *See e.g.* Tamara Tomašegović Doctoral Thesis, FUNCTIONAL MODEL OF PHOTOPOLYMER PRINTING PLATE PRODUCTION PROCESS (University of Zagreb, 2016), incorporated herein by reference. Thus, in addition to exposure time affecting the printing result, the light finishing provided by the UVC LEDs offers at least two more degrees of freedom for optimization of the ink transferring (e.g. ink splitting) properties of the printing plates, which are (a) intensity and (b) spectral composition.

Still another aspect is the improvement of the increased stability for hydrocarbon solvents in print inks. Certain combinations of the UVA main exposure, UVA post exposure and UVC Light finishing can improve the resistance of the photopolymer printing plate against hydrocarbon solvents such as are used in certain inks e.g. for printing of electronic circuitry. Usually photopolymer printing plates are limited to inks based on alcohol or water. Other solvents (e.g. Tetraline - TetraHydonaphtalene; Anisol - Methoxybenzene as used for printing of conductive inks; Toluol -Toluene; and Ethyl Acetate - Ethyl Ethanoate) cause swelling of the polymer, which destroys the durability of the printing plate and the print result. Therefore, polymer printing plates typically have only limited lifetime in print processes that use inks based on other solvents, such as used for the printing of contact bars on silicon wafers for solar cells. A high intensity UVA post exposure in combination with a high intensity UVA main exposure may expand the range of printing applications where photopolymer flexographic printing plates can be used. For example, in some cases, photopolymer flexographic printing plates treated with high intensity (e.g. greater than 100 mW/cm², preferably 100 - 1000 mw/cm², more preferably 250 - 500 mW/cm²) UVA post exposure can replace flexographic printing plates based on elastomers.

Moreover, in all the exemplary embodiments described above, the exposure in the post exposure and light finishing process may be divided into a multitude of two or more exposure cycles so as to provide additional features. These exposure cycles may be arranged in a way that the UVA post exposure and UVC light finishing are executed in an alternating mode with irradiance and/or energy being constant or ascending or descending with increasing number of cycles.

### LED Light Source Embodiments

Methods to arrange the LEDs on a circuit board inside a housing are well known e.g. from the Esko XPS or the Esko Inline UV systems. In these systems LEDs are arranged in a kaleidoscope optic as described in the US Patent US8578854B2, incorporated herein by reference. For the process of post exposure or light finishing, the requirements for homogenous energy distribution are not as demanding as for the process of main exposure. Thus, for post exposure or light finishing, UVA LEDs for the post exposure and the UVC LEDs for the light finishing may be arranged on a circuit board without the need for a kaleidoscope optic. In some cases, beam shaping optics of the LEDs themselves may be used to concentrate the UV radiation inside or at the surface of the polymer printing plate.

As depicted and described above, in some embodiments the light sources may extend only over one dimension of the photopolymer plate and cover the second dimension by means of relative motion, such as are depicted in FIGs. 5 and 6. Also, the light sources may extend over both dimensions of the polymer printing plate without need for relative movement, as depicted in FIG. 7. In still other embodiments, such as are depicted in FIGS. 3 and 4, the light sources may extend over less than a full dimension in both lateral dimensions of the photopolymer plate, and relative movement between the source and the plate may complete the coverage in both lateral dimensions.

In some embodiments, the UVA and UVC light sources may be physically completely separated from each other. Alternatively, the UVA and UVC LEDs may be combined in the same light source housing in a way that all portions of the photopolymer plate may be exposed to both UV wavelengths simultaneously with homogeneous intensity distribution. In such an embodiment, UVA and UVC LEDs may be controlled independently, thereby allowing to select the ratio in intensity and time between UVA and UVC radiation.

### Controlling of the LEDs

Unlike conventional light finishing system having fluorescent tubes, which control only the timing of UVA and UVC curing, in the above-described exemplary embodiments, both intensity and exposure time of each of the UVA LED and UVC LED light sources of the light finishing apparatus 130A can be controlled independently by the central control computer 170A, and both of the intensity and time of the UVA LEDs and UVC LEDs in the UV light exposure and light finishing systems 300-800 can be controlled independently by the respective control systems thereof. Thus, the light finishing with LEDs gets another degree of freedom as both intensity and exposure time can be controlled independently.

Also, the wavelengths can be influenced by using a multitude of LEDs of different emission wavelengths, arranging the LEDs into groups of different wavelengths, controlling each group independently from the others and adjusting the ratio between the different wavelengths by adjusting the intensities of the different groups, as is shown and described in Published US Application No. US20190224958A1, titled METHOD AND APPARATUS FOR EXPOSING PRINTING PLATES USING LIGHT EMITTING DIODES, incorporated herein by reference.

The above-described embodiments disclose the exposure devices, system, and methods that use a plurality of UVA and UVC LEDs or arrays of the UVA and UVC LEDs for the post exposure and the light finishing. As a result, the printing properties of photopolymer printing plates can be improved by independently controlling the wavelengths, intensities, exposure time, and energy composition of the UVA post exposure and UVC finishing.

The UV sources may comprise optics disposed between the UV source and the photopolymer plate, including beam shaping optics, lenses, and mirrors. In embodiments having a supplemental UV source for post exposure and UV finishing (such as in the thermal processor arrangement of Fig.9), it may be sufficient to have only the LEDs arranged on their circuit boards without additional beam shaping optics. In system configurations that include UVA main exposure, kaleidoscope optics may be desired for improved curing results in view of having to cure the support shoulders of the printing dots through the mask as is known in the art, conventional mirrors may absorb certain UV wavelengths. To overcome this problem, conventional mirrors may be replaced by a suitable substrate coated with barium sulfate, which acts as a diffuse Lambertian reflector. An embodiment using a barium sulfate coating may be particularly useful in embodiments in which the UVA main exposure is combined with UVC finishing in the same housing.

### Masking Layer and other Alternative Embodiments

Although described primarily herein in the context of digital flexographic plates embodying a laser-ablatable mask (LAMs) layer, it should be understood that the systems and processes discussed herein are also applicable to any type of plates regardless of the imaging technology used - i.e. imaged with or without masking layers, including plates with film-based imaged masking layers (i.e. having an imageable layer that is thermally sensitive or photosensitive laminated or otherwise disposed over the photocurable layer of the plate for blocking or transmitting radiation to the photocurable layer of the plate in accordance with imaging information), direct imaged plates, or plates imaged by any means known in the art today or developed in the future.

It should also be understood that although primarily discussed herein with respect to arrangements in which the finishing / detacking radiation source is positioned above the front (printing) side of the plate for treatment from the front side, other embodiments may include subjecting the plate to the finishing/detacking radiation from the back side (e.g. through a transparent substrate, as described in more detail above).

Although certain aspects of the invention are particularly useful and advantageous in a flexo environment, the disclosure herein is not limited to any particular type of plate or processing. To the extent ranges are provided herein, the ranges are inclusive of the endpoints (i.e. the range is from the value equal to or greater than the lower value to equal to or less than the greater value), absent an express indication to the contrary.

Although the invention is illustrated and described herein with reference to specific embodiments, the invention is not intended to be limited to the details shown. Rather, various modifications may be made in the details within the scope and range of equivalents of the claims and without departing from the invention.
In the following, further features, characteristics and advantages of the invention will be described by means of items:
1. An apparatus for exposing a partially processed photopolymer printing plate to post-exposure radiation and finishing radiation, the printing plate defining a whole area having a first full lateral dimension and a second full lateral dimension perpendicular to the first lateral dimension, the apparatus comprising:
   a plurality of light-emitting diodes (LEDs) arranged in one or more arrays, the plurality of LEDs including at least a first set of LEDs configured to emit the post exposure radiation in a UVA spectral range and a second set of LEDs configured to emit the finishing radiation in a UVC spectral range;
   a surface for receiving the printing plate in a location disposed to receive the post exposure radiation and the finishing radiation;
   one of more controllers connected to the one or more arrays and configured to activate the one or more arrays to cause the plurality of sets of LEDs to emit radiation toward the printing plate.
2. The apparatus of item 1, wherein the first set of LEDs is arranged in a first lamp and the second set of LEDs is arranged in a second lamp.
3. The apparatus of item 1, wherein the first set of LEDs and the second set of LEDs are arranged in a single lamp.
4. The apparatus of any one of items 1-3, wherein the one or more arrays are configured to expose the whole area of the printing plate.
5. The apparatus of any one of items 1-3, wherein the one or more arrays are configured to expose the full first lateral dimension of the printing plate over less than the full second lateral dimension of the printing plate.
6. The apparatus of item 5, further comprising means for causing relative motion between the printing plate and the one or more arrays.
7. The apparatus of item 6, wherein the one or more arrays are configured to be stationary and the means is configured to move the plate.
8. The apparatus of item 7, wherein the means for causing relative motion includes a drum that defines the surface for receiving the printing plate and that is configured to rotate relative to the one or more arrays.
9. The apparatus of item 6, wherein the surface for receiving the printing plate is configured to hold the printing plate in a stationary configuration, wherein the means for causing relative motion includes a carriage configured to move the one or more arrays in a first lateral direction relative to substrate.
10. The apparatus of any one of items 1-3, wherein the one or more arrays are configured to expose less than the full first lateral dimension of the printing plate over less than the full second lateral dimension of the printing plate.
11. The apparatus of item 10, wherein the means for causing relative motion includes a drum that defines the surface for receiving the printing plate and that is configured to rotate relative to the one or more arrays, and means for moving the one or more arrays axially relative to the drum.
12. The apparatus of item 10, wherein the surface for receiving the printing plate is configured to hold the printing plate in a stationary configuration, wherein the means for causing relative motion includes a gantry configured to move the one or more arrays in a first lateral direction relative to substrate, and a carriage configured to move the one or more arrays relative to the gantry in a second lateral direction perpendicular to the first lateral direction.
13. The apparatus of any one of items 1-12, wherein the one or more controllers includes a first controller configured to independently control power to the first set of LEDs and a second controller configured to independently control power to the second sets of LEDs, wherein the first controller and the second controller are configured to cause the first set of LEDs to emit a different intensity than the second set of LEDs.
14. The apparatus of any one of items 1-13, wherein the one or more controllers are configured to cause at least the first set of LEDs to have a different exposure time than at least the second set of LEDs.
15. The apparatus of any one of items 1-14, wherein the surface for receiving the printing plate is disposed between the plate and the plurality of LEDs.
16. The apparatus of any one of items 1-14, wherein the printing plate is disposed between the plurality of LEDs and the surface for receiving the printing plate.
17. The apparatus of any one of items 1-14, wherein
   the first set of UV LEDs is also configured to emit front side main exposure radiation toward the front side of the printing plate disposed on the surface.
18. The apparatus of item 15, further comprising:
   at least one third set of UV LEDs configured to emit a back side main exposure radiation toward the back side of the printing plate disposed on the surface;
   wherein the one or more controllers is configured to cause the at least one third set of LEDs to emit radiation toward the printing plate.
19. The apparatus of any one of items 1-18, wherein the printing plate further comprises a laser ablated masking (LAMS) layer, and the apparatus further comprises an imager configured to laser ablate the LAMS layer in accordance with imaging information.
20. The apparatus of any one of items 1-19, wherein the apparatus further comprises a plate dryer.
21. The apparatus for any one of items 1-19, wherein the apparatus further comprises a thermal plate processor.
22. A method for exposing a partially processed photopolymer printing plate to post-exposure radiation and finishing radiation, the method comprising:
   a) providing the apparatus of any one of items 1-21, and
   b) disposing a printing plate on the surface;
   c) irradiating the printing plate with post-exposure radiation from the first set of LEDs; and
   d) irradiating the printing plate with the finishing radiation from the second set of LEDs.
23. A method for exposing a partially processed photopolymer printing plate to post-exposure radiation and finishing radiation, the printing plate defining a whole area having a first full lateral dimension and a second full lateral dimension perpendicular to the first lateral dimension, the method comprising:
   a) partially processing the photopolymer printing plate by performing at least a main UV exposure step;
   b) removing non-cured polymer portions of the photopolymer printing plate by at least one of a thermal plate processor, a solvent-based plate processor, or a water-based plate processor;
   c) providing a plurality of light-emitting diodes (LEDs) arranged in one or more arrays, the plurality of LEDs including at least a first set of LEDs configured to emit the post exposure radiation in a UVA spectral range and a second set of LEDs configured to emit the finishing radiation in a UVC spectral range;
   d) irradiating the partially processed photopolymer printing plate with the post exposure radiation from the first set of LEDs for a first exposure time; and
   e) irradiating the partially processed photopolymer printing plate with the finishing radiation from the second set of LEDs for a second exposure time;
   wherein each execution of step (d) and step (e) comprises an exposure cycle, and each exposure cycle defines an energy contribution.
24. The method of item 23, comprising executing two or more consecutive exposure cycles.
25. The method of item 23 or 24, comprising executing step (d) and step (e) simultaneously.
26. The method of item 23 or 24, comprising executing step (d) and step (e) in alternation.
27. The method of any one of items 23-26, wherein the energy contribution per exposure cycle is constant.
28. The method of any one of items 23-26, wherein the energy contribution per exposure cycle increases over time.
29. The method of any one of items 23-26, wherein the energy contribution per exposure cycle decreases over time.
30. The method of any one of items 23-26, wherein the energy contribution per exposure cycle increases over time for one of the first set of LEDs or the second set of LEDs and decreases over time for the other of first set of LEDs or the second set of LEDs.
31. The method of any one of items 23-30, wherein the printing plate defines a whole area having a full first lateral dimension and full second lateral dimension perpendicular to the first lateral dimension, and each of step (c) and step (d) comprise irradiating the whole area of the plate without movement of the plate, the first set of LEDs, or the second set of LEDs.
32. The method of any one of items 23-30, wherein the printing plate defines a whole area having a full first lateral dimension and full second lateral dimension perpendicular to the first lateral dimension, and the one or more arrays are configured to expose the less than one or both of the full first lateral dimension or the second lateral dimension, the method further comprising causing relative movement between the printing plate and the one or more arrays.
33. The method of any one of items 23-32, further comprising independently controlling each of the first set of LEDs and the second sets of LEDs to control one or more of intensity, exposure time, and wavelength composition.
34. The method of item 33, comprising controlling the one or more of intensity, exposure time, and wavelength composition of the first set of LEDs and the second set of LEDs to optimize ink transfer properties of the printing plate.
35. The method of item 23, wherein partially processing the photopolymer flexographic printing plate includes removing uncured polymer after performing the main UV exposure step, the method comprising independently controlling each of the first set of LEDs and the second sets of LEDs to control one or more of intensity, exposure time, and wavelength composition in one or more exposure cycles to optimize durability of the photopolymer flexographic printing plate for use with a solvent-containing printing ink.
36. A method of processing a photosensitive flexographic printing plate, the method comprising the steps of:
   a) performing a main exposure step, including a back exposure substep and a front exposure substep, resulting in cured polymer in the printing plate corresponding to areas of the plate exposed during the main exposure step and uncured polymer corresponding to areas of the plate not exposed during the main exposure step;
   b) removing the non-cured polymer from the printing plate;
   c) optionally, drying the printing plate; and
   d) irradiating the printing plate with a set of UVA LEDs for a first exposure time; and
   e) irradiating the printing plate a set of UVC LEDs for a second exposure time.
37. The method of item 36, further comprising the step of forming a mask over a photosensitive layer of the printing plate;
38. The method of item 37, wherein the printing plate has a Laser Ablated Masking (LAMs) layer disposed over the photosensitive layer of the plate, and the step of forming the mask comprises laser ablating the LAMs layer with an imager in accordance with imaging information.
39. The method of any one of items 36 -38, wherein steps (c), (d), and (e) are performed by a same piece of process equipment.
40. The method of any one of items 36 -38, wherein steps (b), (d), and (e) are performed by a same piece of process equipment.
41. The method of any one of items 36 -38, wherein steps (a), (d), and (e) are performed by a same piece of process equipment.
42. The method of any one of items 36 -38, wherein step (e) is performed after step (a) but before step (b).
43. The method of item 42, further comprising performing step (e) again after performance of steps (b) and (c).
44. The method of any one of items 36 - 38, wherein the step of forming the mask and steps (a), (d), and (e) are performed by a same piece of process equipment.
45. The method of any one of items 36 - 38, wherein the step of forming the mask and steps (a), (c), (d), and (e) are performed by a same piece of process equipment.
46. The method of any one of items 36 - 38, wherein the step of forming the mask and steps (a), (b), optionally (c), (d), and (e) are all performed by a same piece of process equipment.
47. The method of any one of items 36 - 38, steps (d) and (e) are performed using stationary UVA LEDs and stationary UVC LEDs on a moving plate after performance of the drying step (c) downstream of a washing step in step (b).

## Claims

1. A processing system (1) for processing a printing plate (P) comprising:
an imager (10) for imaging a printing plate (P);
an exposure unit (11) for exposing a printing plate (P) imaged by the imager (10);
a developer (12) for developing a printing plate (P) exposed by the exposure unit (11); and
a control device (17) for controlling plate making processes performed by the imager (10), the exposure unit (11) and the developer (12).

2. The processing system (1) of claim 2, further comprising:
a first transport device (14) configured to transport a printing plate (P) from the imager (10) to the exposure unit (11), and
a second transfer device (15) configured to convey a printing plate (P) to the developer (12),
wherein the processing system (1) preferably further comprises:
a plate cutting unit (13) for cutting a printing plate (P) developed by the developer (12), wherein the control device (17) is also configured for controlling a plate making process performed by the plate cutting unit (13), and
a third transport device (16) configured to transport a printing plate from the developer (12) to the plate cutting unit (13).

3. The processing system (1) of claim 1 or 2, wherein the developer (12) comprises a post-exposure unit (83), the post-exposure unit (83) being configured to irradiate a printing plate (P) with UVA radiation from a first set of LEDs and with UVC radiation from a second set of LEDs.

4. The processing system (1) of claim 3, wherein the first set of LEDs is arranged in a first lamp and the second set of LEDs is arranged in a second lamp, or wherein the first set of LEDs and the second set of LEDs are arranged in a single lamp.

5. The processing system (1) of claim 3 or 4, wherein the first set of LEDs and the second set of LEDs are arranged in one or more arrays.

6. The processing system (1) of claim 5, wherein the one or more arrays are configured to expose the whole area of the printing plate.

7. The processing system (1) of claim 5, wherein the one or more arrays are configured to expose a full first lateral dimension of the printing plate over less than a full second lateral dimension of the printing plate.

8. The processing system (1) of claim 6, further comprising means for causing relative motion between the printing plate and the one or more arrays.

9. The processing system (1) of claim 8, wherein the one or more arrays are configured to be stationary and the means for causing relative motion is configured to move the plate.

10. The processing system (1) of claim 9, wherein the means for causing relative motion includes a drum that defines a surface for receiving the printing plate and that is configured to rotate relative to the one or more arrays.

11. The processing system (1) of any one of claims 3 to 10, further comprising:
a first controller configured to control power to the first set of LEDs, and
a second controller configured to control power to the second sets of LEDs, wherein the first controller and the second controller are configured to cause the first set of LEDs to emit a different intensity than the second set of LEDs.

12. The processing system (1) of any one of claims 3 to 11, further configured to cause at least the first set of LEDs to have a different exposure time than at least the second set of LEDs.

13. The processing system (1) of any one claims 3 to 12, wherein the developer (12) further comprises an import unit (80), a developing unit (81), a drying unit (82) and an export unit (84), wherein the import unit (80), the developing unit (81), the drying unit (82), the post-exposure unit (83) and the export unit (84) are linearly oriented.

14. The processing system (1) of claim 13, further comprising a transport device (90) configured to transport the printing plate (P) from the exposure unit (11) to the developer import unit (80), to the developing unit (81), the drying unit (82), the post-exposure unit (83), and the export unit (84), preferably at a constant speed.

15. The processing system (1) of claim 14, wherein the transfer device (90) comprises a transfer path (91) on which the printing plate (P) is placeable and transferred, and a transfer mechanism (92) configured to hold and transfer the printing plate (P) along the transfer path (91).
